# EUROPÄISCHE PATENTSCHRIFT

(11) **EP 1 099 222 B1**
(45) Veröffentlichungstag und Bekanntmachung des Hinweises auf die Patenterteilung: **23.04.2003**
(21) Anmeldenummer: 99942749.5
(22) Anmeldetag: 01.07.1999
(51) Int. Cl.: G11C 11/22

(54) **FERROELEKTRISCHER SCHREIB-/LESESPEICHER MIT IN REIHE GESCHALTETEN SPEICHERZELLEN (CFRAM)**
FERROELECTRIC READ/WRITE MEMORY HAVING SERIES-CONNECTED STORAGE CELLS (CFRAM)
MEMOIRE A LECTURE-ECRITURE FERROELECTRIQUE POURVUE DE CELLULES DE MEMOIRE MONTEES EN SERIE

(30) Priorität: 10.07.1998 DE 19830963
(43) Veröffentlichungstag der Anmeldung: 16.05.2001
(73) Patentinhaber: Infineon Technologies AG, 81669 München (DE)
(72) Erfinder: SCHNEIDER, Ronny, D-99625 Kölleda (DE); BRAUN, Georg, D-80339 München (DE)
(74) Vertreter: Fischer, Volker, Dipl.-Ing.
(86) Internationale Anmeldenummer: DE9901931
(87) Internationale Veröffentlichungsnummer: WO00003396

(56) Entgegenhaltungen:
- DE-A- 19 724 449

## Beschreibung

Die Erfindung betrifft einen Schreib-/Lesespeicher, der pro Speicherzelle einen ferroelektrischen Kondensator und mindestens einen Transistor aufweist. Bei ferroelektrischen Speichern werden die Remanenzzustände der elektrischen Polarisation des Dielektrikums zum Speichern von zwei logischen Zuständen genutzt. Es treten hierbei verschiedene Effekte auf, die die Polarisation anderer Zellen an der gleichen Bit- oder Wortleitung beeinflussen, wobei eventuell deren gespeicherte Information zerstört wird. Liegen bei einem polarisierten Kondensator keine festen Potentiale an, so baut sich aufgrund von Leckströmen zum Substrat eine Spannung auf, die der Polarisation eventuell entgegengerichtet ist. Es ist also notwendig, den Kondensator, sofern er nicht ausgelesen oder beschrieben wird, beidseitig möglichst auf gleichem Potential zu halten.

Aus dem Digest of Technical Papers zum Symposium on VLSI Circuits 1997, Seiten 83 und 84, ist ein ferroelektrischer Speicher bekannt, bei dem eine Mehrzahl von Speicherzellen bzw. ferroelektrischen Kondensatoren in Reihe geschaltet und die jeweiligen Kondensatoren durch jeweils einen zugehörigen Transistor kurzschließbar sind. Damit wird erreicht, daß beide Elektroden eines ferroelektrischen Kondensators auf gleichem Potential gehalten werden, welches, wenn nicht gelesen oder beschrieben wird, sogar konstant ist. Wird eine Zelle gelesen bzw. beschrieben, wird der entsprechende Transistor abgeschaltet. Außerdem wird an die Bitleitung eine Spannung angelegt, die von der Spannung an der nicht mit der Bitleitung verbindbaren Kondensatorplatte deutlich abweicht. Die Differenz der beiden Spannungen bewirkt, daß der ferroelektrische Kondensator bis zur Sättigung geladen wird. Alle anderen Transistoren in einer jeweiligen Reihenschaltung von Speicherzellen bzw. in einem jeweils ausgewählten Speicherzellenblock bleiben während dessen leitend, wodurch sichergestellt wird, daß der Lade- oder Entladestrom durch den ausgewählten Zellenkondensator über die die restlichen Kondensatoren eines Speicherzellenblockes kurzschließenden Transistoren fließen kann. Durch den On-Widerstand der eingeschalteten Transistoren fällt jedoch eine Spannung ab, die auch am zugehörigen ferroelektrischen Kondensator anliegt und je nach Polarisation des ferroelektrischen Kondensators und nach Richtung des Lade- bzw. Entladestroms eine Polarisation begünstigt oder schwächt. Im letzteren Fall treten besagte Spannungsabfälle als Störimpulse in Erscheinung, die bei ausreichender Amplitude und/oder Häufigkeit, die Polarisation derart verändern,daß die gespeicherte Information des ferroelektrischen Kondensators zerstört wird. Durch eine Reihenschaltung möglichst vieler solcher ferroelektrischen Speicherzellen wird der Gesamtwiderstand des Strompfades vergrößert und die Höhe des Stromes verringert, wodurch auch die unerwünschten Störimpulse an den ferroelektrischen Kondensatoren der nicht ausgewählten Speicherzellen verkleinert werden. Dies hat jedoch den Nachteil, daß der Lade- und Entladevorgang des ferroelektrischen Kondensators, der gelesen und beschrieben wird deutlich länger dauert. Aus diesem Grunde werden beim oben angegebenen Stand der Technik mehrere Speicherzellenblöcke, mit beispielsweise aus 16 Einzelzellen bestehenden Reihenschaltungen, vorgesehen. Nachteilig ist hierbei, daß die Störimpulse oftmals unzulässig hoch sind und ein Datenverlust auftritt, weil der On-Widerstand der Transistoren, wegen der hierfür erforderlichen sehr großen Transistorweite bzw. sehr hohen Ladungsträgerbeweglichkeit, nicht beliebig gesenkt werden kann.

Die der Erfindung zugrundeliegende Aufgabe besteht nun darin, einen ferroelektrischen Schreib-/Lesespeicher mit in Reihe geschalteten Speicherzellen anzugeben, bei dem Störspannungen an ferroelektrischen Kondensatoren nicht ausgewählter Speicherzellen und der schaltungstechnische Aufwand möglichst gering sind.

Diese Aufgabe wird erfindungsgemäß durch die Merkmale des Patentanspruchs 1 gelöst. Bevorzugte Weiterbildungen ergeben sich aus den weiteren Ansprüchen.

Die Erfindung wird nachfolgend anhand eines in der Zeichnung dargestellten Beispiels näher erläutert. Dabei zeigen
- Figur 1: ein erstes Ausführungsbeispiel des erfindungsgemäßen ferroelektrischen Schreib-/Lesespeichers,
- Figur 2: ein zweites Ausführungsbeispiel eines erfindungsgemäßen ferroelektrischen Schreib-/Lesespeichers,
- Figur 3: ein Zeitdiagramm der Störspannung bei einer bekannten Speicherzelle,
- Figur 4: ein Zeitdiagramm der Störspannung bei einem Speicher nach Figur 1 und
- Figur 5: ein Zeitdiagramm der Störspannung bei einem Speicher nach Figur 2.

Die Erfindung besteht im wesentlichen darin, daß zum ferroelektrischen Kondensator einer jeweiligen Speicherzelle ein Widerstand bzw. ein speziell angesteuerter Transistors in Reihe geschaltet wird und auf diese Weise Störimpulse, die durch das Auslesen der jeweiligen adressierten Speicherzelle erzeugt werden, an ferroelektrischen Kondensatoren gerade nicht adressierter Speicherzellen, verringert bzw. beseitigt werden, wobei die Zugriffszeit nicht unzulässig erhöht wird.

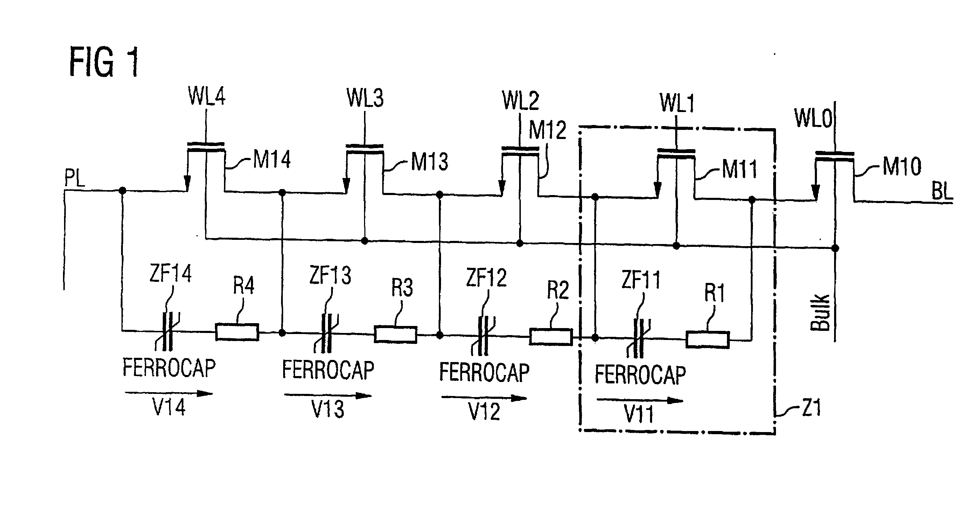

In Figur 1 ist ein erstes Ausführungsbeispiel in Form eines Speicherblockes mit vier in Reihe geschalteten ferroelektrischen Speicherzellen dargestellt, wobei die Reihenschaltung der vier Speicherzellen über einen Auswahltransistor M10, der über eine Wortleitung WL0 ansteuerbar ist, mit einer Bitleitung BL verbindbar ist. Alle vier in Reihe geschalteten Speicherzellen sind, wie beispielsweise eine erste Speicherzelle 21 aufgebaut. Die Zelle 21 weist einen ferroelektrischen Kondensator ZF11, einen dazu in Reihe geschalteten Widerstand R1 auf und dieser Reihenschaltung ist ein Transistor M11 parallel geschaltet, dessen Gate mit einer Wortleitung WL1 verbunden ist. In entsprechender Weise sind in den anderen drei Zellen weitere ferroelektrische Kondensatoren ZF12 ... ZF14, weitere Widerstände R2 ... R4 und weitere Transistoren M12 ... M14 vorgesehen, beschaltet und über weitere Wortleitungen WL2 ... WL4 ansteuerbar. Die Bitleitung BL ist über den Auswahltransistor M10 und die Reihenschaltung aus den Transistoren M11 ... M14 mit einem Knoten PL verbindbar, der typischerweise einen Spannungspegel von etwa VDD/2 aufweist. Die Transistoren M10 ... M14 weisen vorteilhafterweise einen gemeinsamen Substratanschluß Bulk auf.

Durch ein entsprechendes Signal auf der Wortleitung WL0 kann eine Zelle eines ausgewählten Blocks auf die Bitleitung BL ausgelesen werden. Wird beispielweise die Zelle Z1 ausgelesen, so erhalten die Wortleitungen WL2 ... WL4 ein entsprechendes Signal, daß die Transistoren M12 ... M14 leitend werden und die nicht ausgewählten Zellen, also in diesem Fall die jeweiligen Reihenschaltungen aus den ferroelektrischen Kondensatoren und Widerständen, durch diese Transistoren überbrückt werden und der Transistor M11 durch ein Signal auf der Wortleitung WL1 derart angesteuert wird, daß dieser sperrt. Hierdurch wird bewirkt, daß die Bitleitung BL über den Auswahltransistor M10 über den Widerstand R1 und den ferroelektrischen Kondensator ZF11 sowie über die leitenden Transistoren M12 ... M14 mit dem Spannungspegel PL verbunden ist. Die durch die On-Widerstände der Transistoren M12 ... M14 hervorgerufenen Spannungsabfälle liegen jeweils über der Reihenschaltung aus dem jeweiligen ferroelektrischen Kondensator und dem zugehörigen Widerstand, zum Beispiel ZF12 und R2, wodurch die Störspannungen V12 ... V14 über den eigentlichen ferroelektrischen Kondensatoren ZF12 ... ZF14 aufgrund des Lesestromes der Zelle Z1 gegenüber dem Stand der Technik wesentlich verringert wird.

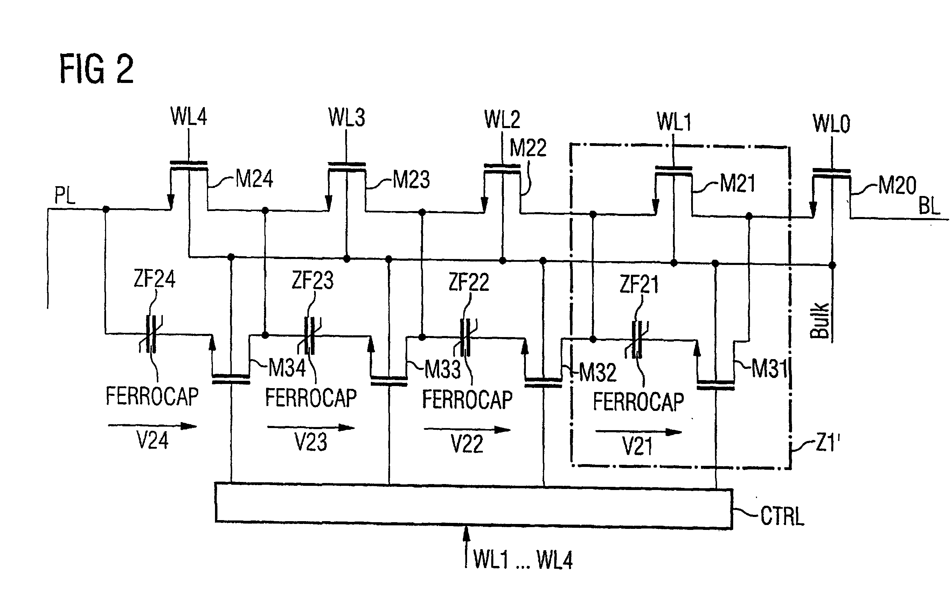

In Figur 2 ist ein weiteres Ausführungsbeispiel der Erfindung dargestellt, das sich von dem in Figur 1 dargestellten Ausführungsbeispiel im wesentlichen dadurch unterscheidet, daß die den ferroelektrischen Kondensatoren in Reihe geschalteten Widerstände R1 ... R4 durch weitere Transistoren M31 ... M34 ersetzt sind, deren Gateanschlüsse über eine Steuereinrichtung CTRL in Abhängigkeit der Signale auf den Wortleitungen WL1 ... WL4 ansteuerbar sind. Anstelle der Zelle Z1, die über den Transistor M10 mit der Bitleitung verbunden ist, ist hier eine Zelle Z1' vorgesehen, die über einen Transistor M20 mit der Bitleitung verbunden ist und deren ferroelektrischer Kondensator ZF21 mit dem Transistor M31 in Reihe geschaltet ist und diese Reihenschaltung durch einen Transistor M21 überbrückbar ist. In entsprechender Weise sind die Transistoren M12 ... M14 von Figur 1 in Figur 2 mit M22 ... M24, die Kondensatoren ZF12 ... ZF14 von Figur 1 in Figur 2 mit ZF22 ... ZF24 bezeichnet. Desweiteren liegen über den ferroelektrischen Kondensatoren ZF22 ... ZF24 die Störspannungen V22 ... V24 an.

Vorteilhafterweise sind hier die Substratanschlüsse aller Transistoren mit einem gemeinsamen Anschluß Bulk verbunden.

Die Funktionsweise ist ähnlich wie bei der Anordnung von Figur 1, wobei mit Hilfe der Steuereinheit CTRL der zum Kondensator der ausgewählten Zelle in Reihe geschaltete Transistor, z. B. Transistor M31, leitend geschaltet wird und die zu den Kondensatoren der nicht ausgewählten Zellen in Reihe geschalteten Transistoren, z.B. die Transistoren M32 ... M34, durch die Einheit CTRL so angesteuert werden, daß sie gerade noch nicht ganz sperren.

Würden die zu den Kondensatoren der nicht ausgewählten Zellen in Reihe geschalteten Transistoren, z.B. die Transistoren M32 ... M34, ganz sperren, dann wären die Störimpulse größer als bei nicht ganz sperrendenTransistoren, da die Diffusionskapazitäten, die Gate-Source-Kapazitäten und die Drain-Source-Kapazitäten dieser Transistoren mit den ferroelektrischen Kondensatoren kapazitive Spannungsteiler bilden würden.

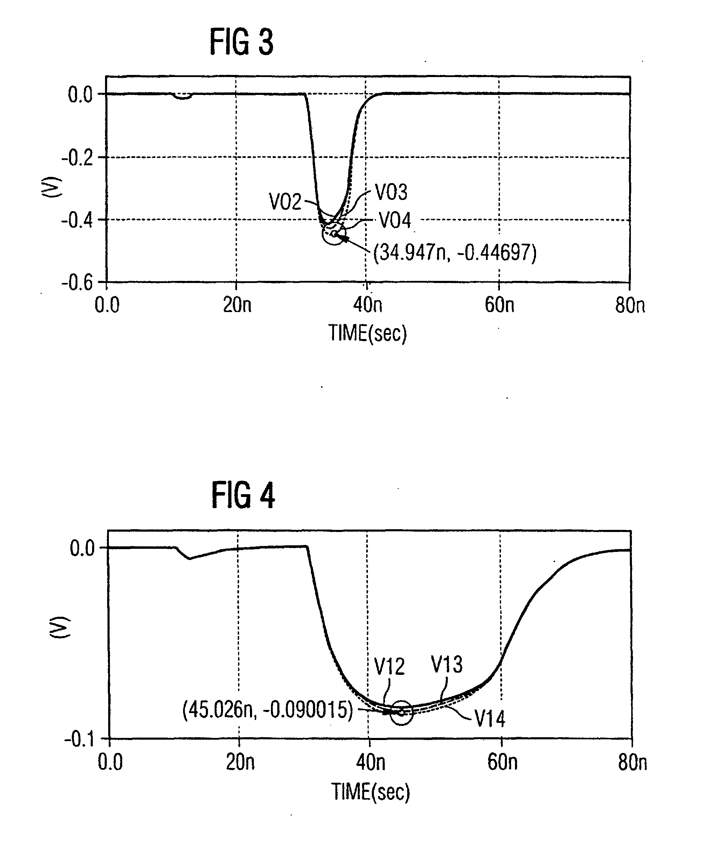

In Figur 3 sind in einem Diagramm Störspannungen V02 ... V04 für den bekannten Fall angegeben, daß die ferroelektrischen Kondensatoren, ohne einen jeweils in Reihe geschalteten Widerstand bzw. Transistor, direkt parallel zum jeweiligen Transistor geschaltet sind, wobei die Störspannungspegel hier beispielsweise bei ca. - 0,4 Volt liegen, was bereits in der Größenordnung der Koerzitivspannung übliche ferroelektrischer Kondensatoren liegt.

In Figur 4 sind in einem Zeitdiagramm die Störspannungen V12 ... V14 an den ferroelektrischen Kapazitäten ZF12 ... ZF14 von nicht ausgewählten Speicherzellen dargestellt, wobei die Widerstände R1 ... R4 in Figur 1 zum Beispiel in der Größenordnung von 100 kΩ sind. Die Störspannungen V12 ... V14 weisen jeweils einen Wert unter - 0,1 Volt auf, was deutlich geringer ist als die Koerzitivspannung bei üblichen ferroelektrischen Kondensatoren.

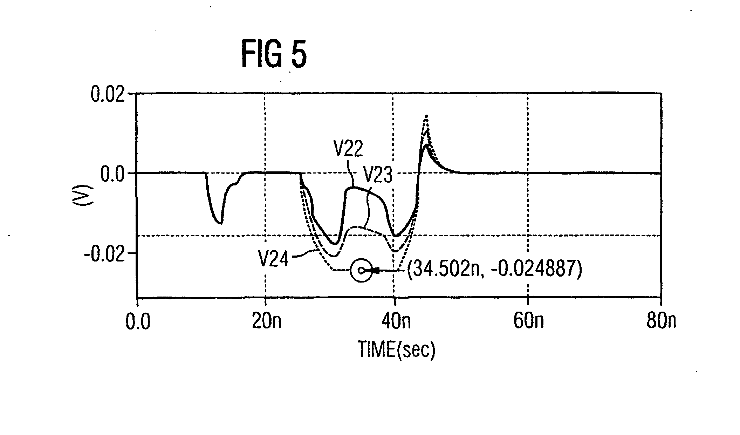

Für einen ferroelektrischen Speicher gemäß Figur 2, also mit zu den ferroelektrischen Kondensatoren jeweils in Reihe geschaltete Transistoren, sind in Figur 5 die Störspannungen V22 ... V24 an den ferroelektrischen Kondensatoren der nicht ausgewählten Speicherzellen dargestellt, wobei die Werte der Störspannungen nochmals erheblich kleiner sind als bei einem Speicher mit den zu den ferroelektrischen Kondensatoren in Reihe geschalteten Widerständen, wobei der Zeitverlust in der Zugriffszeit nicht wesentlich schlechter ist als bei bekannten ferroelektrischen Speichern dieser Art.

## Patentansprüche

1. Ferroelektrischer Schreib-/Lesespeicher mit einer Mehrzahl von in Reihe geschalteten Speicherzellen (Z1), bei dem eine jeweilige Speicherzelle (Z1) einen jeweiligen ferroelektrischen Kondensator (ZF11), einen Widerstand (R1) und einen Transistor (M11) aufweist, bei dem dem jeweiligen ferroelektrischen Kondensator (ZF11) der jeweilige Widerstand (R1) in Reihe geschaltet ist und bei dem der Reihenschaltung aus dem ferroelektrischen Kondensator (ZF11) und dem jeweiligen Widerstand (R1) der jeweilige Transistor (M11) parallel geschaltet ist, dessen Gate mit einer jeweiligen Wortleitung (WL1) verbunden ist.

2. Ferroelektrischer Schreib-/Lesespeicher nach Anspruch 1, bei dem der jeweilige Widerstand (R1) durch einen jeweiligen weiteren Transistor (M31) ersetzt ist, dessen Leitfähigkeit in Abhängigkeit eines von der jeweiligen Wortleitung geführten Signals steuerbar ist.

3. Ferroelektrischer Schreib-/Lesespeicher nach Anspruch 2, bei dem eine Steuereinheit (CTRL) vorhanden ist, die ausgebildet ist, um durch das von der jeweiligen Wortleitung (WL1) geführte Signal eine Speicherzelle (Z1') auszuwählen und um in Abhängigkeit dieses Signals den jeweiligen weiteren Transistor (M31) dieser ausgewählten Speicherzelle leitend zu schalten und um alle anderen weiteren Transistoren (M32 ... M34) der nicht ausgewählten Speicherzellen so anzusteuern, daß diese anderen weiteren Transistoren (M32 ... M34) gerade noch nicht sperren.

## Claims

1. Ferroelectric read/write memory with a plurality of memory cells (Z1) connected in series, in which a respective memory cell (Z1) has a respective ferroelectric capacitor (ZF11), a resistor (R1) and a transistor (M11), in which the respective resistor (R1) is connected in series with the respective ferroelectric capacitor (ZF11), and in which the respective transistor (M11), whose gate is connected to a respective word line (WL1), is connected in parallel with the series circuit composed of the ferroelectric capacitor (ZF11) and the respective resistor (R1).

2. Ferroelectric read/write memory according to Claim 1, in which the respective resistor (R1) is replaced by a respective further transistor (M31), whose conductivity can be controlled as a function of a signal carried by the respective word line.

3. Ferroelectric read/write memory according to Claim 2, in which a control unit (CTRL) is provided which is designed to select a memory cell (Z1') by means of the signal carried by the respective word line (WL1) and switch on the respective further transistor (M31) of this selected memory cell as a function of this signal and in order to drive all the other further transistors (M32 ... M34) of the non-selected memory cells to just before the switch-off threshold of these other further transistors (M32 ... M34).

## Revendications

1. Mémoire ferroélectrique à écriture/lecture ayant une pluralité de cellules (Z1) de mémoire montées en série, dans laquelle une cellule (Z1) respective de mémoire a un condensateur (ZF11) ferroélectrique respectif, une résistance (R1) et un transistor (M11), dans laquelle la résistance (R1) respective est montée en série avec le condensateur (ZF11) ferroélectrique respectif et dans laquelle le circuit série constitué du condensateur (ZF11) ferroélectrique et de la résistance (R1) respective est monté en parallèle au transistor (M11) respectif dont la grille est reliée à une ligne (WL1) de mot respective.

2. Mémoire ferroélectrique à écriture/lecture suivant la revendication 1, dans laquelle la résistance (R1) respective est remplacée par un transistor (M31) respectif dont la conductivité peut être commandée en fonction d'un signal acheminé par la ligne de mot respective.

3. Mémoire ferroélectrique à écriture/lecture suivant la revendication 2, dans laquelle il est prévu une unité (CTRL) de commande qui est constituée pour sélectionner par le signal acheminé par la ligne (WL1) de mot respective une cellule (Z1') de mémoire et pour rendre passant en fonction de ce signal l'autre transistor (M31) respectif de cette cellule de mémoire sélectionnée et pour commander tous les autres transistors (M32...M34) supplémentaires de cellules de mémoire qui n'ont pas été sélectionnées de façon à ce que ces autres transistors (M32...M34) supplémentaires ne soient juste pas encore bloqués.
